# EUROPÄISCHE PATENTSCHRIFT

(11) **EP 3 710 333 B1**
(45) Veröffentlichungstag und Bekanntmachung des Hinweises auf die Patenterteilung: **11.05.2022**
(21) Anmeldenummer: 18807008.0
(22) Anmeldetag: 13.11.2018
(51) Int. Cl.: B62D 1/06, H05B 1/02, B60N 2/56

(54) **BAUELEMENT UND VERFAHREN ZUR BELEGUNGSERKENNUNG EINES BAUELEMENTS**
COMPONENT AND METHOD FOR IDENTIFYING AN OCCUPANT CONTACT OF A COMPONENT
ÉLÉMENT STRUCTURAL ET PROCÉDÉ DE DÉTECTION D'OCCUPATION D'UN ÉLÉMENT STRUCTURAL

(30) Priorität: 17.11.2017 DE 102017220540
(43) Veröffentlichungstag der Anmeldung: 23.09.2020
(73) Patentinhaber: Volkswagen AG, 38440 Wolfsburg (DE); Ge-t GmbH, 85055 Ingolstadt (DE)
(72) Erfinder: BOESE, Christoph, 38302 Wolfenbüttel (DE); NICKEL, Patrick, 02991 Lauta (DE); OTTE, Roland, 38557 Osloß (DE); QUANDER, Nils, 38154 Königslutter (DE); KNOBLOCH, Markus, 38524 Sassenburg (DE); KUJELIS, Kim Alexander, 38154 Königslutter (DE)
(74) Vertreter: Zucker, Volker
(86) Internationale Anmeldenummer: PCT/EP2018/081065
(87) Internationale Veröffentlichungsnummer: WO 2019/096780

(56) Entgegenhaltungen:
- WO-A1-2016/087231
- US-A1- 2015 102 024

## Beschreibung

Bauelement und Verfahren zur Belegungserkennung eines Bauelements Die Erfindung betrifft ein Bauelement mit integrierter Belegungserkennung und Heizfunktion sowie ein Verfahren zur Belegungserkennung eines Bauelementes.

Es sind verschiedene Bauelemente bekannt, die eine Belegungserkennung aufweisen. Beispielsweise sind Fahrzeugsitze mit Sitzbelegungssensoren bekannt, Des Weiteren sind Lenkräder mit sogenannter hands-off-detection bekannt, also ob der Kraftfahrzeugführer die Hände am Lenkrad hat oder nicht. Auch dies stellt eine Belegungserkennung dar, nämlich ob das Lenkrad durch die Hände belegt ist oder nicht.

Aus der DE 203 09 603 U1 ist ein Bauelement in Form einer Lenkeinrichtung für ein Kraftfahrzeug bekannt, mit mindestens einem Betätigungsabschnitt zur Betätigung der Lenkeinrichtung und einer Sensoreinrichtung zur Erfassung einer Betätigung der Lenkeinrichtung, wobei die Sensoreinrichtung durch mindestens ein kapazitives Sensorelement gebildet wird. Dabei ist weiter vorgesehen, dass die Sensoreinrichtung durch mindestens eine am Betätigungsabschnitt der Lenkeinrichtung vorgesehene elektrische Leiteranordnung gebildet wird. Dabei können auch mindestens zwei separate Sensorelemente vorgesehen sein, die jeweils verschiedenen Bereichen des Betätigungsabschnitts der Lenkeinrichtung zugeordnet sind, sodass eine ortsaufgelöste Belegung detektierbar ist. Schließlich wird noch vorgeschlagen, dass die Sensorelemente zugleich als Heizelemente dienen.

Aus der WO 2016/087231 A1, welche die Merkmale der Oberbegriffe der unabhängigen Ansprüche 1 und 7 offenbart, ist ein Sensorsystem für ein Lenkrad eines Kraftfahrzeugs mit wenigstens einer kapazitiven Sensoreinrichtung und einer Steuereinrichtung zur Ansteuerung der Sensoreinrichtung bekannt, wobei die kapazitive Sensoreinrichtung wenigstens zwei elektrisch leitfähige Sensorstrukturen aufweist und zur Erkennung einer Anwesenheit einer menschlichen Hand in einem Greifbereich eines Lenkrads ausgebildet ist. Zusätzlich können auch Heizstrukturen vorhanden sein. Dabei wird auch vorgeschlagen, dass wenigstens eine Sensorstruktur durch eine Heizstruktur gebildet wird. In diesem Fall muss das Sensorsystem allerdings derart ausgebildet sein, dass die Heizstruktur während der Erfassung der Änderung der kapazitiven Kopplung der Sensorstruktur mit der Umgebung und/oder einer

Referenzelektrode allpolig abgeschaltet werden kann, d.h. sowohl vom Pluspol als auch vom Minuspol vollständig getrennt werden kann.

Aus der US 2015/0102024 A1 ist eine Lenkradheizung mit Belegungserkennung bekannt, wobei wechselweise Heiz- und Sensierströme fließen können, wobei die Sensierströme eine kleinere Amplitude aufweisen.

Der Erfindung liegt das technische Problem zugrunde, ein Bauelement mit integrierter Belegungserkennung und Heizfunktion weiter zu verbessern sowie ein Verfahren zur Belegungserkennung eines Bauteils zur Verfügung zu stellen.

Die Lösung des technischen Problems ergibt sich durch eine Baueinheit mit den Merkmalen des Anspruchs 1 sowie ein Verfahren mit den Merkmalen des Anspruchs 7. Weiter vorteilhafte Ausgestaltungen der Erfindung ergeben sich aus den Unteransprüchen.

Hierzu umfasst das Bauelement mit integrierter Belegungserkennung und Heizfunktion mindestens eine Auswerte- und Steuereinheit sowie mindestens zwei elektrische Leiter, die voneinander unabhängig bestromt werden können und verschiedenen Bereichen des Bauelements zugeordnet sind. Dabei ist die Auswerte- und Steuereinheit derart ausgebildet, durch Auswertung einer kapazitiven Änderung der elektrischen Leiter ortsaufgelöst eine Belegung des Bauelements zu erfassen, wobei in Abhängigkeit einer erfassten Belegung die elektrische Energie im zugeordneten Leiter erhöht wird. Hierdurch kann gezielt nur der Bereich erwärmt werden, für den auch eine Belegung erfasst wurde, sodass der elektrische Energieverbrauch ohne Komfortverlust spürbar reduziert werden kann. Es existiert also ein erster Betriebsmodus, wo die Belegung sensiert wird und ein zweiter Betriebsmodus, wo geheizt wird. Die Erhöhung der Energie ist gleichbedeutend, dass die zeitlich gemittelte elektrische Leistung erhöht wird. Die Erhöhung der elektrischen Energie kann beispielsweise durch eine Erhöhung der Spannung oder des Stromes erfolgen. Erfindungsgemäß ist jedoch das Signal an den elektrischen Leitern ein PWM-Signal, wobei die Auswerte- und Steuereinheit derart ausgebildet ist, zur Erhöhung der elektrischen Energie im zweiten Betriebsmodus das Pulsein- zu Pulsausverhältnis anzupassen.

In einer Ausführungsform ist vorgesehen, dass das PWM-Signal abwechselnd aus mindestens einem Messsignal zum Detektion einer Belegung des Bauelementes und einem Signal zum Durchführen der Heizfunktion besteht. Dabei kann auch insbesondere vorgesehen sein, dass wenn erstmalig nach mehreren Messsignalen zum Detektieren einer Belegung eine Belegung erfasst wurde, anschließend ein Signal zum Durchführen der Heizfunktion und eine Messsignal zum Detektieren einer Belegung abwechselnd erzeugt werden.

In einer weiteren Ausführungsform ist die Auswerte- und Steuereinheit derart ausgebildet, dass die Heizfunktion deaktivierbar ist und/oder eine Heizfunktion für das komplette Bauelement einstellbar. Beispielsweise kann die Deaktivierung oder die Heizfunktion für das komplette Bauelement durch eine Benutzereingabe erfolgen. Alternativ oder ergänzend kann die Einstellung auch automatisch in Abhängigkeit der Daten eines Temperatursensors erfolgen, sodass beispielsweise bei Temperaturen oberhalb eines ersten Grenzwertes die Heizfunktion deaktiviert wird und/oder bei Temperatur unterhalb eines zweiten Grenzwertes das komplette Bauelement beheizt wird. Weiter ist es möglich die elektrische Energie zum Heizen in Abhängigkeit von einer Temperatur einzustellen, sodass beispielsweise bei niedrigen Temperaturen mit größerer Energie geheizt wird. Die Temperatur kann dabei eine Außentemperatur oder eine Temperatur im Inneren eines Kraftfahrzeuges sein.

Alternativ oder ergänzend kann mindestens ein Temperatursensor oder ein Mittel zum Schätzen der Temperatur im Bauelement verbaut sein, um die erreichte Temperatur beim Heizen zu erfassen, um so beispielsweise die Heizfunktion zu drosseln oder abzuschalten, falls eine bestimmte Temperatur erreicht ist. Vorzugsweise ist dabei jedem Bereich mit einem elektrischen Leiter ein eigener Temperatursensor zugeordnet.

In einer weiteren Ausführungsform weist das Bauelement eine Entkopplungsschaltung auf, die die Messstrecke der Kapazitätsänderung von der Spannungsversorgung signaltechnisch entkoppelt. Die Entkopplungsschaltung ist beispielsweise als Filterschaltung ausgebildet und verhindert störende kapazitive Einflüsse.

In einer weiteren Ausführungsform ist die Auswerte- und Steuereinheit mit einer Referenzelektrode verbunden, die ein definiertes Gegenfeld gegen die elektrischen Leiter zur Verfügung stellt. Die Referenzelektrode ist beispielsweise ein Kupferblech, d. h. es wird eine Kapazitätsänderung zwischen dem elektrischen Leitern und der Referenzelektrode ermittelt.

In einer weiteren Ausführungsform ist das Bauelement ein Lenkrad oder ein Fahrzeugsitz oder eine Armlehne oder eine Fußmatte.

Hinsichtlich der verfahrensmäßigen Ausgestaltung wird vollinhaltlich auf die vorangegangen Ausführungen Bezug genommen.

Die Erfindung wird nachfolgend anhand bevorzugter Ausführungsbeispiele näher erläutert. Die Fig. zeigen:
- Fig. 1: eine schematische Schaltungsanordnung für eine Belegungserkennung und Heizfunktion,
- Fig. 2: eine Darstellung eines Lenkrades,
- Fig. 3: eine Schnittdarstellung durch einen Lenkkranz,
- Fig. 4: eine weitere Darstellung eines Lenkrades und
- Fig. 5: eine Darstellung eines PWM-Signals.

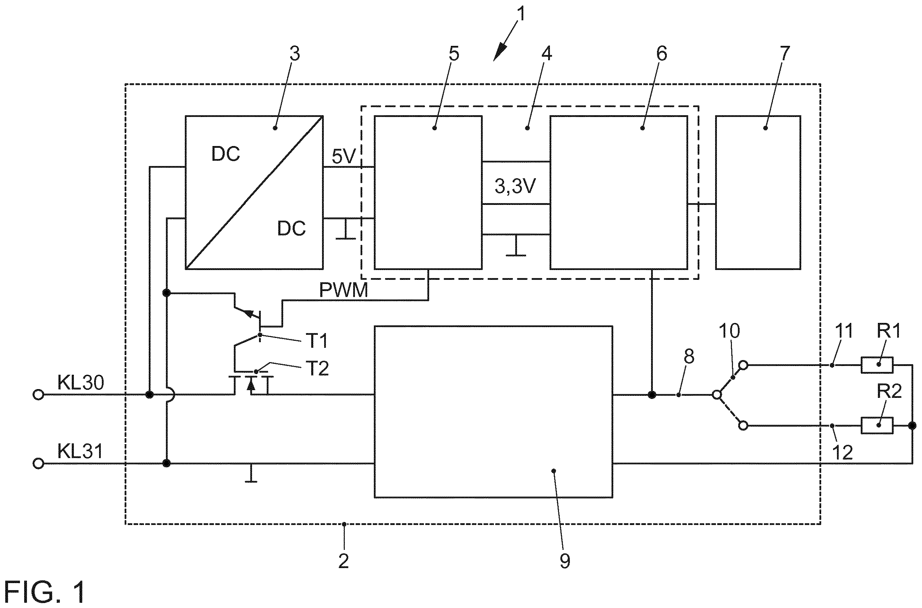

In der Fig. 1 ist eine Schaltungsanordnung 1 zur Erfassung einer Belegung eines Bauelements dargestellt, wobei ein Großteil der Elemente auf einer Platine 2 angeordnet sind. Die Schaltungsanordnung 1 weist zwei Spannungsanschlüsse KL30, KL31 auf, die mit einer nicht dargestellten Batterie verbunden sind. Die Schaltungsanordnung 1 weist weiter einen DC/DC-Wandler 3 auf, mittels dessen die Batteriespannung in eine Betriebsspannung für eine Auswerte- und Steuereinheit 4 gewandelt werden kann. Im dargestellten Ausführungsbeispiel umfasst die Auswerte- und Steuereinheit 4 einen Mikroprozessor 5 sowie einen Messchip 6 auf. Der Messchip 6 ist mit einer Referenzelektrode 7 und mindestens einer elektrischen Leitung 8 verbunden. Des Weiteren ist zwischen den Spannungsanschlüssen KL30, KL31 und der Leitung 8 eine Entkopplungsschaltung 9 angeordnet. Die Leitung 8 ist über ein Schaltelement 10 wahlweise mit einer ersten elektrischen Leitung 11 oder einer zweiten elektrischen Leitung 12 verbindbar, die jeweils einen ohmschen Widerstand aufweisen, was durch die dargestellten Widerstände R1, R2 symbolisiert ist. Die erste elektrische Leitung 11 und die zweite elektrische Leitung 12 sind in unterschiedlichen Bereichen des Bauelements verlegt, was später noch näher erläutert wird. Dabei sei angemerkt, dass die Anzahl der elektrischen Leitungen 11, 12 auch größer sein kann. Des Weiteren sei angemerkt, dass alternativ zu dem Schaltelement 10 auch vorgesehen sein kann, dass die elektrischen Leitungen 11, 12 auch gleichzeitig parallel betrieben werden.

Die Auswerte- und Steuereinheit 4 erzeugt nun ein PWM-Ansteuersignal das dann beispielsweise mittels zweier Transistoren T1, T2 in ein PWM-Signal umgesetzt wird. Die Auswerte- und Steuereinheit 4 steuert dann das Schaltelement 10 beispielsweise derart an, dass die erste elektrische Leitung 11 mit der Leitung 8 verbunden ist, wobei durch die Auswerte- und Steuereinheit 4 eine Kapazität bzw. Kapazitätsänderung gemessen wird. Ist das Bauelement beispielsweise ein Lenkrad, so ändert sich die Kapazität, wenn eine Hand auf den Bereich der ersten elektrischen Leitung 11 aufliegt. Wird eine solche Belegung erfasst, so wird eine Heizfunktion durchgeführt, indem die Pulseinzeit verlängert wird. Dies Verfahren wird dann mit der zweiten elektrischen Leitung 12 wiederholt. Somit kann gezielt zunächst sensiert werden, ob und wo das Bauelement belegt ist und dann gezielt nur der Bereich erwärmt werden, der auch belegt ist. Die Sensierung wird dann periodisch wiederholt, um Änderungen in der Belegung zu erfassen.

Dabei kann die Auswerte- und Steuereinheit 4 derart ausgebildet sein, dass die Heizfunktion deaktivierbar ist, beispielsweise weil der Nutzer die Funktion nicht nutzen möchte oder weil äußere Bedingungen dagegen sprechen (Außentemperaturen größer einen erstem ersten Grenz- oder Schwellwert).

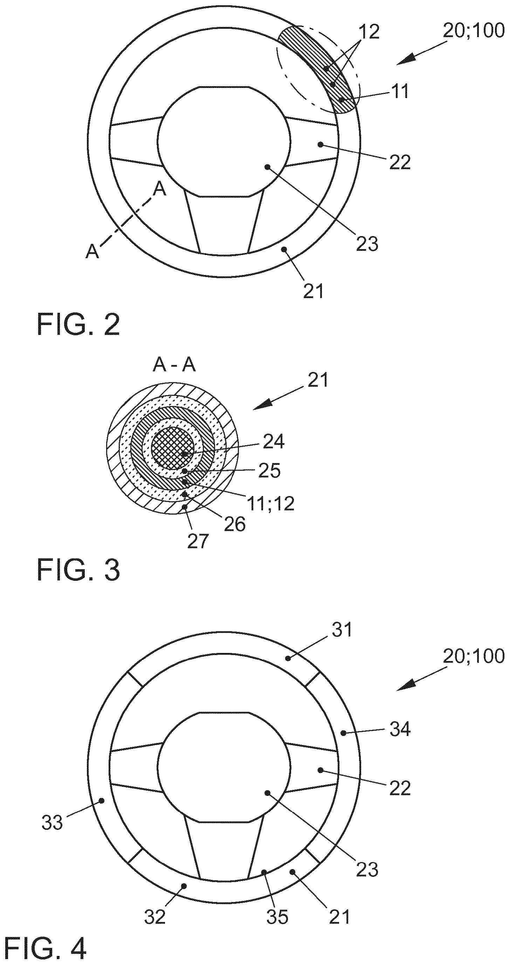

In der Fig. 2 ist ein Lenkrad 20 als Bauelement 100 dargestellt. Das Lenkrad 20 weist einen Lenkkranz 21, Lenkradspeichen 22 sowie einen Mittelbereich 23 auf, wobei die elektrischen Leiter 11, 12 (s. Fig. 1) im Lenkkranz 21 sowie die Schaltungsanordnung 1 im Mittelbereich 23 angeordnet sind, wobei aus Darstellungsgründen ein Teil der Verkleidung des Lenkkranzes 21 entfernt wurde, sodass die elektrischen Leiter 11, 12 sichtbar sind.

In der Fig. 3 ist eine Schnittdarstellung durch den Lenkkranz 21 entlang der Schnittlinie A-A dargestellt. Mittig ist ein Skelett 24 vorhanden, auf dem eine erste Schaumschicht 25 angeordnet ist, auf der dann die elektrischen Leiter 11, 12 angeordnet sind. Dabei können die elektrischen Leiter 11, 12 auf einem flexiblen Substrat wie beispielsweise Textil angeordnet sein. Um die elektrischen Leiter 11 ist dann eine optionale zweite Schaumschicht 26 und darüber eine Lederschicht 27 angeordnet.

In der Fig. 4 ist ein weiteres Lenkrad 20 als Bauelement 100 dargestellt. Dabei weist das Lenkrad 20 fünf elektrisch Leiter auf, die fünf Bereichen 31 - 35 zugeordnet sind. Vereinfach ausgedrückt sind die Bereiche 31 - 35 oben, unten, links, rechts und innen, wobei der elektrische Leiter für den Bereich 35 vorzugsweise über den gesamten Umfang verläuft. Durch den innenliegenden Leiter kann insbesondere ein Umgreifen des Lenkrades 20 detektiert werden.

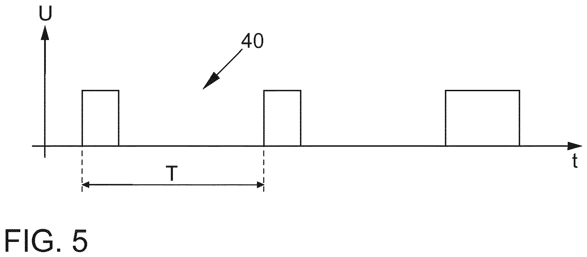

Schließlich ist in Fig. 5 beispielhaft ein PWM-Signal 40 dargestellt, dass eine Periodendauer T aufweist. Dabei ist Spannung U über der Zeit t dargestellt. Dabei sind die beiden ersten PWM-Signale Messsignale, um eine Belegung eines Bauelementes 100 zu detektieren, wobei bei dem dritten Signal die Pulseinzeit verlängert ist, um die Heizfunktion nach einer Detektion einer Belegung durchzuführen. Dabei kann das PWM-Signal auch eine andere Form aufweisen. Entscheidend für die Heizfunktion ist nur, dass das Verhältnis von Pulsein- zu Pulsauszeit verlängert wird.

## Patentansprüche

1. Bauelement (100) mit integrierter Belegungserkennung und Heizfunktion, umfassend mindestens eine Auswerte- und Steuereinheit (4) sowie mindestens zwei elektrische Leiter (11, 12), die voneinander unabhängig bestromt werden können und verschiedenen Bereichen (31 - 35) des Bauelementes zugeordnet sind, wobei die Auswerte- und Steuereinheit (4) derart ausbildet ist, durch Auswertung einer kapazitiven Änderung der elektrischen Leiter (11, 12) ortsaufgelöst eine Belegung des Bauelementes zu erfassen, wobei
die Auswerte- und Steuereinheit (4) derart ausgebildet ist, in Abhängigkeit einer erfassten Belegung die elektrischen Energie im zugeordneten elektrischen Leiter (11, 12) zu erhöhen,
**dadurch gekennzeichnet, dass**
ein Signal für die Erfassung der Belegung an den elektrischen Leitern (11, 12) ein PWM-Signal (40) ist, wobei die Auswerte- und Steuereinheit (4) derart ausgebildet ist, zur Erhöhung der elektrischen Energie für die Heizfunktion bei erfasster Belegung das Pulsein- und Pulsausverhältnis anzupassen.

2. Bauelement nach Anspruch 1, **dadurch gekennzeichnet, dass** das PWM-Signal (40) abwechselnd aus mindestens einem Messsignal zum Detektieren der Belegung des Bauelementes (100) und einem Signal zum Durchführen der Heizfunktion besteht.

3. Bauelement nach einem der vorangegangenen Ansprüche, **dadurch gekennzeichnet, dass** die Auswerte- und Steuereinheit (4) derart ausgebildet ist, dass die Heizfunktion deaktivierbar ist und/oder eine Heizfunktion für das komplette Bauelement einstellbar ist.

4. Bauelement nach einem der vorangegangenen Ansprüche, **dadurch gekennzeichnet, dass** das Bauelement (100) eine Entkopplungsschaltung (9) aufweist.

5. Bauelement nach einem der vorangegangenen Ansprüche, **dadurch gekennzeichnet, dass** die Auswerte- und Steuereinheit (4) mit einer Referenzelektrode verbunden ist.

6. Bauelement nach einem der vorangegangen Ansprüche, **dadurch gekennzeichnet, dass** das Bauelement (100) als Lenkrad (20), Fahrzeugsitz, Armlehne oder Fußmatte ausgebildet ist.

7. Verfahren zur Belegungserkennung eines Bauelements (100), mittels mindestens einer Auswerte- und Steuereinheit (4) sowie mindestens zwei elektrischen Leitern (11, 12), die voneinander unabhängig bestromt werden können und verschiedenen Bereichen (31 - 35) des Bauelementes (100) zugeordnet sind, wobei die Auswerte- und Steuereinheit (4) durch Auswertung einer kapazitiven Änderung der elektrischen Leiter (11, 12) ortsaufgelöst eine Belegung des Bauelementes (100) erfasst, wobei die Auswerte- und Steuereinheit (4) in Abhängigkeit einer erfassten Belegung die elektrische Energie im zugeordneten elektrischen Leiter (11, 12) erhöht,
**dadurch gekennzeichnet, dass**
an die elektrischen Leiter (11, 12) ein PWM-Signal (40) als Signal für die Erfassung der Belegung angelegt wird, wobei bei einer erfassten Belegung das PWM-Signal (40) im Pulsein- und Pulsausverhältnis angepasst wird, um die elektrische Energie im zugeordneten elektrischen Leiter (11, 12) für die Heizfunktion zu erhöhen.

## Claims

1. Component (100) with integrated occupancy detection and heating function, comprising at least one evaluation and control unit (4) and at least two electrical conductors (11, 12), which can be energized independently of one another and are assigned to different areas (31 - 35), wherein the evaluation and control unit (4) is designed in such a way that an occupancy of the component is detected in a spatially resolved manner by evaluating a capacitive change in the electrical conductors (11, 12), wherein
the evaluation and control unit (4) is designed in such a way that the electrical energy in the associated electrical conductor (11, 12) is increased as a function of a detected occupancy,
**characterized in that**
a signal for detecting the occupancy on the electrical conductors (11, 12) is a PWM signal (40), wherein the evaluation and control unit (4) is designed to adjust the pulse input and pulse output ratio in order to increase the electrical energy for the heating function when occupancy is detected.

2. Component according to Claim 1, **characterized in that** the PWM signal (40) consists alternately of at least one measurement signal for detecting the occupancy of the component (100) and one signal for performing the heating function.

3. Component according to either of the preceding claims, **characterized in that** the evaluation and control unit (4) is designed in such a way that the heating function is deactivatable and/or a heating function for the complete component is adjustable.

4. Component according to any one of the preceding claims, **characterized in that** the component (100) has a decoupling circuit (9).

5. Component according to any one of the preceding claims, **characterized in that** the evaluation and control unit (4) is connected to a reference electrode.

6. Component according to any one of the preceding claims, **characterized in that** the component (100) takes the form of a steering wheel (20), vehicle seat, armrest or foot mat.

7. Method for detecting occupancy of a component (100), by means of at least one evaluation and control unit (4) and also at least two electrical conductors (11, 12), which can be energized independently of one another and which are assigned to different areas (31 - 35) of the component (100), wherein the evaluation and control unit (4) detects an occupancy of the component (100) in a spatially resolved manner by evaluating a capacitive change in the electrical conductors (11, 12), wherein the evaluation and control unit (4) increases the electrical energy in the associated electrical conductor (11, 12) as a function of a detected occupancy,
**characterized in that**
a PWM signal (40) is applied to the electrical conductors (11, 12) as a signal for the detection of occupancy, wherein, in the case of a detected occupancy, the PWM signal (40) is adjusted in the pulse input and pulse output ratio in order to increase the electrical energy in the associated electrical conductor (11, 12) for the heating function.

## Revendications

1. Élément structural (100) doté d'un système de détection d'occupation et d'une fonction de chauffage, comprenant au moins une unité d'évaluation et de commande (4) ainsi qu'au moins deux conducteurs électriques (11, 12), qui peuvent être alimentés en courant indépendamment l'un de l'autre et sont associés à différentes zones (31 - 35) de l'élément structural, dans lequel l'unité d'évaluation et de commande (4) est conçue de manière à détecter avec résolution spatiale une occupation de l'élément structural, par évaluation d'une modification capacitive des conducteurs électriques (11, 12), dans lequel
l'unité d'évaluation et de commande (4) est conçue de manière à augmenter, en fonction d'une occupation détectée, l'énergie électrique dans le conducteur électrique associé (11, 12),
**caractérisé en ce que**
un signal pour la détection de l'occupation sur les conducteurs électriques (11, 12) est un signal PWM (40), dans lequel l'unité d'évaluation et de commande (4) est conçue de manière à adapter le rapport de marche et d'arrêt des impulsions pour augmenter l'énergie électrique pour la fonction de chauffage lors de la détection de l'occupation.

2. Élément structural selon la revendication 1, **caractérisé en ce que** le signal PWM (40) est constitué en alternance d'au moins un signal de mesure pour détecter l'occupation de l'élément structural (100) et d'un signal de mise en oeuvre de la fonction de chauffage.

3. Élément structural selon l'une quelconque des revendications précédentes, **caractérisé en ce que** l'unité d'évaluation et de commande (4) est conçue de manière à ce que la fonction de chauffage puisse être désactivée et/ou à ce qu'une fonction de chauffage puisse être réglée pour tout l'élément structural.

4. Élément structural selon l'une quelconque des revendications précédentes, **caractérisé en ce que** l'élément structural (100) est un circuit de découplage (9).

5. Élément structural selon l'une quelconque des revendications précédentes, **caractérisé en ce que** l'unité d'évaluation et de commande (4) est reliée à une électrode de référence.

6. Élément structural selon l'une quelconque des revendications précédentes, **caractérisé en ce que** l'élément structural (100) est conçu comme un volant (20), un siège de véhicule, un accoudoir ou un tapis de sol.

7. Procédé de détection d'occupation d'un élément structural (100), au moyen d'au moins une unité d'évaluation et de commande (4) ainsi qu'au moins deux conducteurs électriques (11, 12), qui peuvent être alimentés en courant indépendamment l'un de l'autre et sont associés à différentes zones (31 - 35) de l'élément structural (100), dans lequel l'unité d'évaluation et de commande (4) détecte avec résolution spatiale une occupation de l'élément structural (100) par évaluation d'une modification capacitive des conducteurs électriques (11, 12), dans lequel l'unité d'évaluation et de commande (4) augmente, en fonction d'une occupation détectée, l'énergie électrique dans le conducteur électrique associé (11, 12),
**caractérisé en ce que**
un signal PWM (40) est appliqué aux conducteurs électriques (11, 12) en guise de signal pour la détection de l'occupation, dans lequel, lors d'une occupation détectée, le signal PWM (40) est adapté en rapport de marche et d'arrêt d'impulsions, afin d'augmenter l'énergie électrique dans le conducteur électrique associé (11, 12) pour la fonction de chauffage.
